Europäisches Patentamt

(19) European Patent Office

Office européen des brevets

(11) EP 0 841 806 A2

(12) EUROPEAN PATENT APPLICATION

(43) Date of publication:
13.05.1998 Bulletin 1998/20

(51) Int. Cl.$^6$: H04N 1/06

(21) Application number: 97305500.7

(22) Date of filing: 23.07.1997

(84) Designated Contracting States:
AT BE CH DE DK ES FI FR GB GR IE IT LI LU MC NL PT SE

(30) Priority: 06.11.1996 JP 293494/96

(71) Applicant:
Kabushiki Kaisha Kaneda Kikai Seisakusho
Toyonaka-shi, Osaka-fu (JP)

(72) Inventor: Hosokawa, Junichi
Abiba-ken (JP)

(74) Representative:
Crump, Julian Richard John
F J Cleveland & Company,
40/43 Chancery Lane
London WC2A 1JQ (GB)

(54) **Improvements in or relating to apparatus and methods for exposing printing plates**

(57) Provided is a method of exposing printing plates, particularly printing plates for use in newspaper printing, which plates are substantially rectangular, which method comprises winding a plate on a substantially cylindrical, rotary plate carrier drum; causing or allowing said drum to rotate such that the plate is moved progressively passed an exposing means for image-wise exposing the plate; causing or allowing relative translational movement of the exposing means and drum in a direction substantially parallel to the rotational axis of the drum; and intermittently actuating the exposing means; such that the image is formed on the plate in a plurality of contiguous, spiral strips, with one strip being formed in each full rotation of the drum; characterised by arranging said plate spirally on the drum relative to the rotational axis of the drum with a pitch substantially equal to the width of each image strip in the axial direction, and by advancing the actuation time of the exposing means relative to the angular velocity of the drum such that the strips form a rectangular image on the plate. Preferably, the exposing means is arranged obliquely relative to the axis of the drum, such that each image strip is rectangular.

Figure 9A

EP 0 841 806 A2

## Description

The present invention provides improvements in or relating to apparatus and methods for exposing printing plates, particularly printing plates for use in newspaper printing.

Such printing plates are substantially rectangular and generally comprise a flexible aluminium sheet on which is coated a layer of photo-sensitive material such, for example, as an organic photo-conductor ("OPC"). In use the plates are wound one at a time onto a substantially cylindrical, rotatory drum for moving the plates progressively past an exposing device such as a laser scanning head for image-wise exposing the plates. The exposing device produces an electrostatic latent image on the photo-sensitive material, which image can be developed using charged toner particles and fixed in ways which will be known to those skilled in the art.

The photo-sensitive printing plates can be carried exteriorly or interiorly of the rotatory drum, and generally the exposing device, which receives an image signal from a computer, is adapted to form an image on the plate as a plurality of discrete, contiguous image strips.

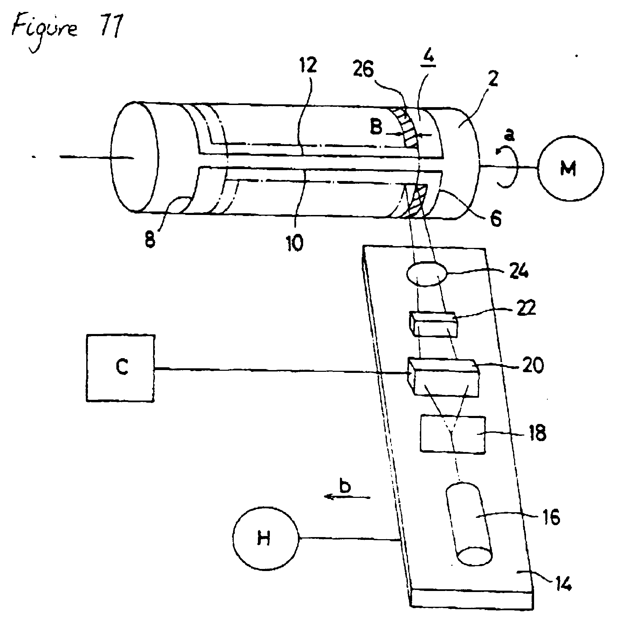

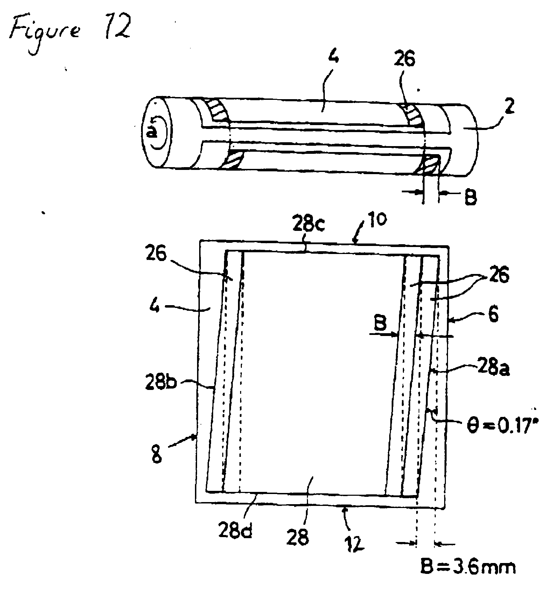

An example of a prior art apparatus for exposing printing plates is illustrated in Figures 11 and 12. With reference to Figure 11, which is a schematic view of the apparatus in perspective, the apparatus comprises a rotatory drum (2) that is adapted to carry a printing plate (4) on its outer surface. The drum (2) is operably connected to a motor M for rotation about an its axis as indicated by the arrow a. Juxtaposed the drum (2) is disposed an exposure device which comprises a movable bed (14) that is operably connected to a driving means H for moving the bed (14) translationally in a direction substantially parallel to the axis of the drum. Said bed (14) carries a laser light source (16) such, for example, as a semi-conductor laser or the like, a beam splitter (18) such, for example, as a grating, Wollerston polarising prism or the like, an acoustical optical modulator ("AOM") unit (20), a light-transmitting array (22) and a lens (24). A beam of laser light generated by the source (16) is split by the beam splitter (18) in a plurality of beams, which beams pass through the AOM unit (20). Said AOM unit (20) is switch-controlled by an image signal from a computer C. The modulated beams are then transmitted by the array (22) which comprises a bundle of optical fibres. The beams are then focused onto the plate by the lens (24). As the drum (20) rotates, the beams produce a latent image on the plate in a strip (26) of width B. Contemporaneous with the rotation of the drum, the optical bed (14) is moved translationally in the direction indicated by arrow b, so that as the drum completes one full turn, the bed (14) is displaced axially by a distance equal to the strip width B.

It will be seen that the plate is arranged on the drum (2) such that two opposing edges (6,8) of the plate are disposed circumferentially with respect to the drum (2) and each defines a plane that is substantially orthogonal to the axis of the drum (2). The other two opposing edges (10,12) are arranged substantially parallel to each other and to the drum axis. Exposure of the plate is started in one corner of the plate that is bounded by one of the circumferential edges (6) called the "start edge", and one of the axial edges (10), called the "leading edge". The other circumferential edge (8) is known as the "end edge", and the other axial edge (12) is referred to as the "trailing edge". There is generally a small clearance between the leading and trailing edges (10,12) of the plate. The exposure unit is operated intermittently at the same frequency as the rotation of the drum, such that the image is produced on the plate in discrete strips as described above. Operation of the exposure unit is interrupted briefly as the clearance between the leading and trailing edges (10,12) of the plate passes closest to the exposure unit.

A problem that is inherent in the prior art method of exposing printing plates is that the image strips (26) are formed spirally on the plates (4) is illustrated in Figure 12. The image (28) is thus formed on the plate in the form of a rhombus. The leading and trailing edges (28c, 28d) of the image (28) are oriented substantially parallel to the leading and trailing edges (10,12) of the plate, but the start and end edges (28a, 28b) of the image extend obliquely relative to the start and end edges of the plate.

In apparatus for exposing printing plates for use in newspaper printing, the circumference of the drum is typically 116.8cm (46 inches), and the picture element density is 358 dots/cm (909 dpi). A light transmitting array (22) of 128 beams width is used, such that the strip width B is 128/358 which is 3.6mm (0.14 inches). In other words, the image strips (26) are formed on the plate (4) at a pitch of 3.6mm, and the start and end edges (28a, 28b) subtend an angle of $0.17^{\circ}$ (calculated from $\theta = 0.14/46$) with the start and end edges (6,8) of the plate (4). This distortion of the image is visible and is undesirable.

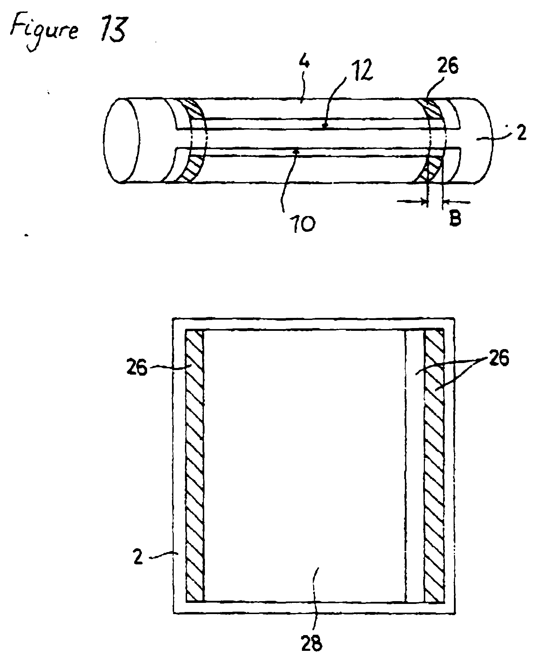

One solution to this problem which has been proposed in the prior art is illustrated in Figure 13. According to this solution, the translational movement of the exposure device is carried out step-wise, so that the image strips (26) are formed on the plate (4) substantially circumferentially and parallel to the start and end edges (6,8) of the plate (4). Whilst this solution completely avoids the problem of forming spiral image strips on a rectangular plate, it suffers from the substantial disadvantage that exposure of the plate has to be interrupted whilst the exposure unit is moved. It will be appreciated that in fact exposure must be interrupted to enable the drum (4) to complete an integer number of complete revolutions, so as to enable continued exposure to begin again juxtaposed the leading edge (10) of the plate (4). Thus the operating efficiency of the exposure is reduced, and the total exposure time for one plate is several times as long as that for the spiral recording method. In addition, the step-wise movement of the exposure unit gives rise to vibration of the optical source which, in turn, leads to deterioration of the image and increased wear of the apparatus. The provision of an intermittent moving mechanism also significantly increases the complexity and cost of the apparatus.

Accordingly, it is an object of the present invention to provide an improved method of exposing printing plates, particularly printing plates for use in newspaper printing.

In particular, it is an object of the present invention to provide apparatus and method for exposing printing plates in which an exposing device can be moved continuously in relation to a plate carrier drum and which, at the same time, avoids or substantially avoids distortion of the resultant image.

In one aspect of the present invention therefore there is provided a method of exposing printing plates, which plates are substantially rectangular, and which method comprises winding a plate on a substantially cylindrical, rotatory plate carrier drum; causing or allowing said drum to rotate such that the plate is moved progressively passed an exposing means for image-wise exposing the plate; causing or allowing relative translational movement of the exposing means and drum in a direction substantially parallel to the rotational axis of the drum; and intermittently actuating the exposing means; such that the image is formed on a plate in a plurality of contiguous, spiral strips, with one strip being formed in each full rotation of the drum; characterised by arranging said plate spirally on the drum relative to the rotation axis of the drum with a pitch substantially equal to the width of each image strip in the axial direction, and by advancing the actuation time of the exposing means relative to the angular velocity of the drum such that the strips form a rectangular image on the plate.

In a different aspect of the present invention there is provided apparatus for exposing printing plates which comprises an exposing means; a substantially cylindrical, rotatory plate carrier drum that is adapted to carry a substantially rectangular printing plate thereon for progressive movement passed the exposing means for image-wise exposing the plate; moving means for causing or allowing relative translational movement of the drum and exposing means in a direction substantially parallel to the rotational axis of the drum; and actuating means for intermittently actuating the exposing means such that an image is formed on the drum as a plurality of contiguous, spiral strips with one strip being formed in each full rotation of the drum; characterised by plate positioning means for positioning the plate spirally on the drum relative to the axis of the drum with a pitch substantially equal to the width of each image strip in the axial direction, and timing means for advancing the timing of the actuation means relative to the angular velocity of the drum such that the image is formed rectangularly on the plate.

It will be apparent therefore that in accordance with the present invention by positioning the plate obliquely on the carrier drum, the image strips are formed substantially parallel to the start and end edges of the plate. It will further be apparent that by placing the plates obliquely on the drum, the leading and trailing edges of the plate are inclined with respect to the axis of the drum. Accordingly, by advancing the timing of the exposure actuation for each revolution of the drum, the leading and trailing edges of the image can be formed substantially parallel to the leading and trailing edges of the plate.

Typically, the exposing means may comprise a linear array of beams, with the length of the linear array defining the width of each image strip. Preferably therefore the array is also oriented relative to the drum axis such that the array of beams incident on the plate is substantially parallel to the leading and trailing edges of the plate, so that the strips are formed rectangularly.

In some embodiments, the exposing means may be moved translationally relative to the drum. Alternatively, the drum may be moved translationally relative to the exposing means.

Said drum may be adapted to carry the plate interiorly of the drum. Alternatively, the plate may be carried on an outer surface of the drum.

As the plate is positioned obliquely on the drum, such that its leading and trailing edges subtend an angle with the drum axis, it will be understood that the leading and trailing edges of the plate extend circumferentially about the drum. Accordingly, in order to ensure that the leading and trailing edges of the image are formed substantially parallel to the leading and trailing edges of the plate, each successive image strip must be started at a point earlier in the rotation of the drum than the previous strip. The timing of the exposure actuation can be controlled by reference to the rotational position of the drum, and for this purpose detecting means may be provided for detecting the position of the drum. Alternatively, the exposure means may be actuated at a constant frequency, and the rotational speed of the drum may be linked to the frequency of the exposure actuation.

Following is a description by way of example only with reference to the accompanying drawings of methods of carrying the present invention into effect.

In the drawings:-

Figure 1 is a schematic, perspective view of apparatus for exposing printing plates in accordance with the present invention.

Figure 2a shows part of the apparatus of Figure 1 in which the position of the printing plate on the drum has been exaggerated.

Figure 2b shows the printing plate of Figure 2a removed from the drum.

Figure 3 is a detail of an image formed on a printing plate in accordance with the present invention.

Figure 4 is a block diagram of a timing device for use in the apparatus of Figure 1.

Figure 5 is a timing diagram for the apparatus of Figure 1.

Figure 6 shows a plan view of a printing plate produced in accordance with the present invention.

Figure 7 is a block diagram of a second timing device for use in the apparatus of Figure 1.

Figure 8 is a detail of another image formed in accordance with the present invention.

Figure 9a shows schematically part of the apparatus of Figure 1.

Figure 9b shows the image-wise exposed plate of Figure 9a removed from the drum.

Figure 10 is another perspective view of part of the apparatus of Figure 1 showing guiding means for guiding the plate onto the drum.

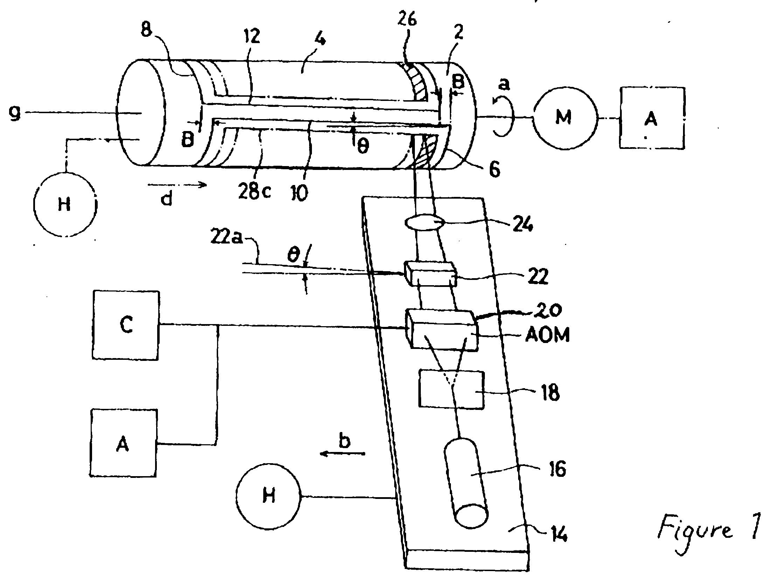

The basic construction and arrangement of the exposure apparatus as illustrated in Figure 1 to 10 is broadly similar to the prior art apparatus illustrated in Figures 11 and 12. Accordingly, components of the apparatus in accordance with the present invention that are common with the prior art apparatus are accorded the same reference numerals in Figures 1 to 10. The apparatus shown in Figure 1 thus comprises a substantially cylindrical, rotatory drum (2) that is adapted to carry a flexible, photo-sensitive printing plate (4) on its outer surface. Said drum (2) is operably connected to the output of a driving means M such as a motor for driving the drum about its axis g in the direction indicated by the curved arrow a.

Adjacent the drum (2) is disposed an exposure unit comprising a movable optical stand (14) that carries a light source (16), typically laser, a beam splitter (18), an acoustic optical modulation unit AOM, a light-transmitting array (22) and a lens (24). As with the prior art apparatus illustrated in Figures 11 and 12, the optical stand (14) is operably connected to a moving means H for moving the optical stand (14) translationally in a direction indicated arrow b that is substantially parallel to the axis of rotation g of the drum (2). In an alternative embodiment, the exposure unit may be immovable, and the drum (2) may be arranged for progressive translational movement relative to the optical stand (14) in the direction indicated by the chain dot arrow d parallel to axis g.

A beam of light emitted by the light source (16) is split into a plurality of beams by beam splitter (18) which may be a grating, a Wollerston polarising prism or the like. The acoustical optical modulator unit (20) has an input that is connected to the output of a computer C for receiving image data from the computer. The multi-beam from the beam splitter (18) is incident on the AOM unit and is modulated thereby such that the multi-beam transmitted by the AOM unit and incident on the array (22) carries the image. Said array (22) comprises a plurality of discrete, light transmitting elements such as optical fibres which are arranged as a linear array. In the present embodiment, 128 such elements are provided. The image-carrying multi-beam transmitted by the array (22) is thus transmitted in the form of discrete beams or pixels, that are focused by the lens (24) onto the printing plate (4) on the drum (2).

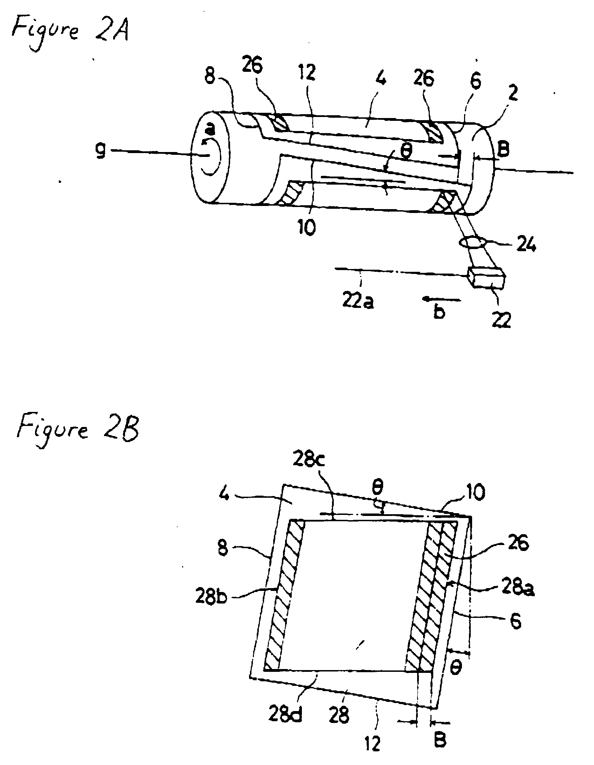

Said plate is substantially rectangular (rectangular herein includes square) and comprises a flexible aluminium backing sheet or substrate with an organic photo-conductive layer thereon. Positive electrical charges may be applied to the photo-sensitive layer of the plate (4) by corona discharge in a manner which is well known to those skilled in the art, and subsequent irradiation of the plate by the image elements from the exposure unit causes the generation of an electro-static latent image on the plate, which latent image can be subsequently developed by the application of charged toner particles and fixed in known ways. From Figures 1 and 2a, it will be seen that the printing plate (4) as applied to the plate-carrying drum (2) comprises two opposing edges adjacent the respective ends of the drum, which edges extend principally circumferentially about the drum. The plate further comprises two other opposing edges (10,12) that extend principally in a direction parallel to rotational axis g of the drum. It will further be seen however that the plate (4) is wrapped spirally on the drum, so that the plate is arranged obliquely relative to the axis g: this exaggerated in Figure 2a. The angle subtended by the axis g and the generally axial opposing edges (10,12) of the plate is designated $\theta$.

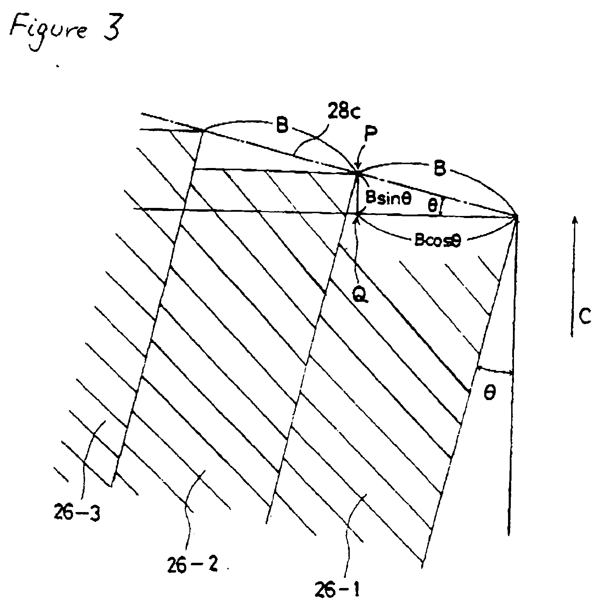

In operation, the drum (2) is rotated progressively about axis g at a substantially constant speed whilst the latent image is formed on the plate by means of the exposure unit. Exposure of the plate is commenced in one corner of the plate that is bounded by one of the principally circumferential edges (6) (the "start edge") and one of the principally axial edges (10) (the "leading edge") of the plate. The latent image is formed on the plate in strips (26), each strip having a width that is defined by the width of the image element array transmitted by the lens (24). This width is shown in the Figures as B. As the drum (2) rotates about its axis g, the optical stand (14) is caused or allowed move progressively in direction b such that for each complete revolution of the drum (2), the displacement of the optical stand (14) in direction b is equal to B. When the plate (4) is positioned on the drum (2) there is a clearance between the leading edge (10) of the plate and the opposing, generally axial edge (12) (the "trailing edge"). As this clearance passes nearest the exposure unit, the exposing beam is interrupted by the computer, and is resumed when the leading edge (10) is closest the exposure unit. The image is thus formed on the plate (4) is a plurality of discrete, contiguous strips (26-1, 26-2, 26-3, etc.) (see Figure 3).

In accordance with the present invention, the degree to which the plate is placed on the drum in spiral fashion is such that the pitch of the spiral is equal or substantially equal to B, that is the projected displacement of the start edge (6) of the plate (4) (or its opposing edge (8) - the "end edge") in the axial direction. For a drum of 116.8cm (46 inches) circumference with an image and a density of 358 dots/cm (909 dpi) and an array (22) of 128 light elements, B = 3.6mm (0.14 inches) and $\theta = 0.17°$.

It will be apparent from Figures 2a and 2b that if, as in the prior art exposure methods described above, the frequency of actuation of the exposure unit is the same as the angular velocity of the drum, then the leading edge (28c) of the image that is built-up on the plate will extend substantially parallel to the axis g of the drum (2). This is clearly undesirable, because as formed on the plate (4), the resultant image (28) will have the shape of a rhombus; the leading and trailing edges (28c,28d) of the image (28) will subtend angle $\theta$ to the leading and trailing edges (10,12) of the plate (4).

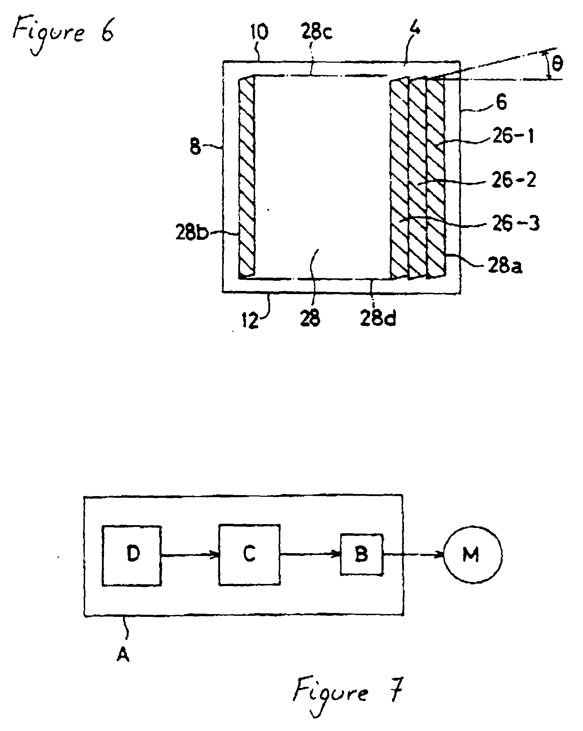

To correct this in accordance with the present invention, the timing of actuation of the exposure unit is advanced relative to the rotational speed of the drum. In other words, for each revolution of the drum (2) actuation of the exposure unit, and thus the start of each strip (26-1, 26-2, 26-3, ...) takes place slightly earlier in the cycle than for the preceding strip. As seen from Figure 3, in order to compensate the distortion of the image which arises from positioning the plate (4) obliquely on the drum (2), the leading edge of each strip must be displaced by $B\sin\theta$ in a direction orthogonal to the rotational axis g of the drum. Thus where the rotational speed of the drum is 100 RPM, $\theta$ is 0.17° and B is 3.56mm (0.14 inches), then actuation of the exposure unit must take place $5.4 \times 10^{-6}$ seconds ($\Delta t$) earlier than for the preceding cycle. This is illustrated in Figure 5 where T represents the duration of one complete revolution of the drum (2) which is constant, and TB represents the period of time taken to produce one strip which is also constant. It will be seen that for each cycle, the leading edge of TB is advantaged with respect to T by $\Delta t$.

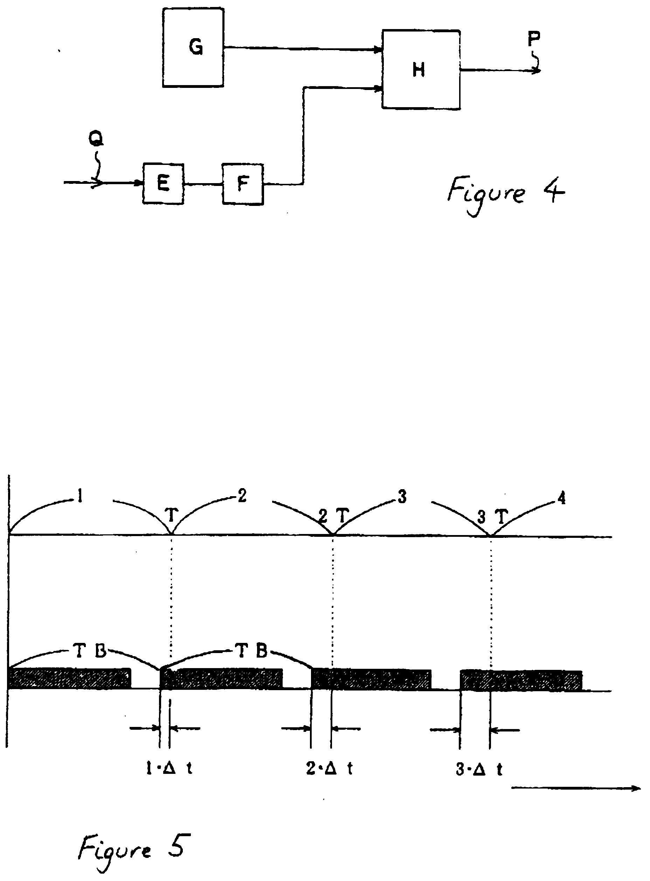

This advancement of the operation of the exposure unit relative to rotation of the drum can be achieved in a variety of ways. For example, rotation of the drum (2) by means of motor M, and displacement of the optical bed (14) by means of driving unit H can be achieved by the use of known clock devices. Alternatively, a position detecting sensor (not shown) may be provided for detecting the rotational position of the drum. An output signal Q (see Figure 4) from the position detecting sensor is provided to a variable time delay unit E, the output of which is inputted to a memory controlling unit F. The output of the memory controlling unit F is inputted to a buffer memory H which also receives input from a memory unit G. The effect of the memory controlling unit F is to adjust the timing of the output of an image signal P to the exposure unit.

In another alternative, the frequency of actuation of the exposure unit (1/TB) is used as a reference, and the rotational speed of the drum (2) is controlled in relation to this reference. The drum revolution period T is longer than TB by $\Delta t$, and thus the drum has to be positioned short of completion of one revolution by $\Delta t$ in time or $B\sin\theta$ in distance at the time of completion of one cycle of strip formation, TB. Thus, the revolution period T of the drum is $D/(D-B\sin\theta)$ seconds , where D is the circumference of the drum. In other words, the revolution speed of the drum is controlled to be $(D-B\sin\theta)/D$ times as fast as the frequency of actuation of the exposure unit 1/TB .

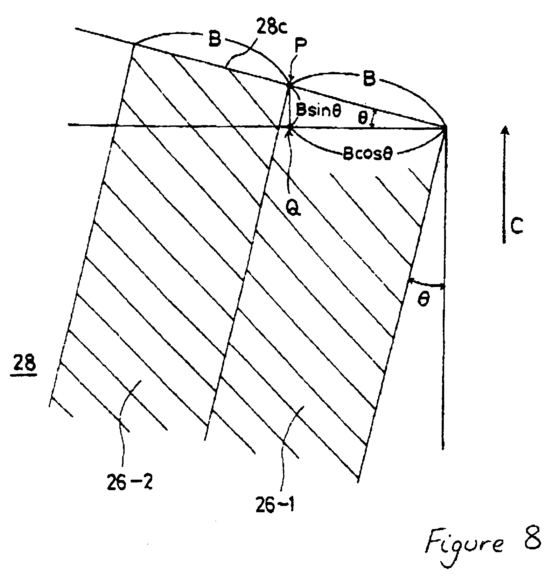

A timing mechanism A for controlling the speed of rotation of the drum (2) is illustrated in chain-dot lines in Figure 1. With reference to Figure 7, this mechanism A comprises a crystal oscillator D, the output of which is divided by a frequency divider C. A phase shifter B is interposed between the frequency divider C and the input of the motor M. A separate crystal oscillator is provided for reading the buffer memory from the computer C. It is the latter crystal oscillator that sets the actuation frequency of the exposure unit by controlling the time at which the computer buffer memory is read. Where the oscillation frequency of the crystal oscillator for reading the buffer memory is 10 MHz, the oscillation frequency of the crystal oscillator D for determining the angular velocity of the drum (2) is set at $(D-B\sin\theta)/D$ times 10 MHz , i.e 9.9999097 MHz for the aforementioned values of the drum diameter D, the strip width B and the angle $\theta$.

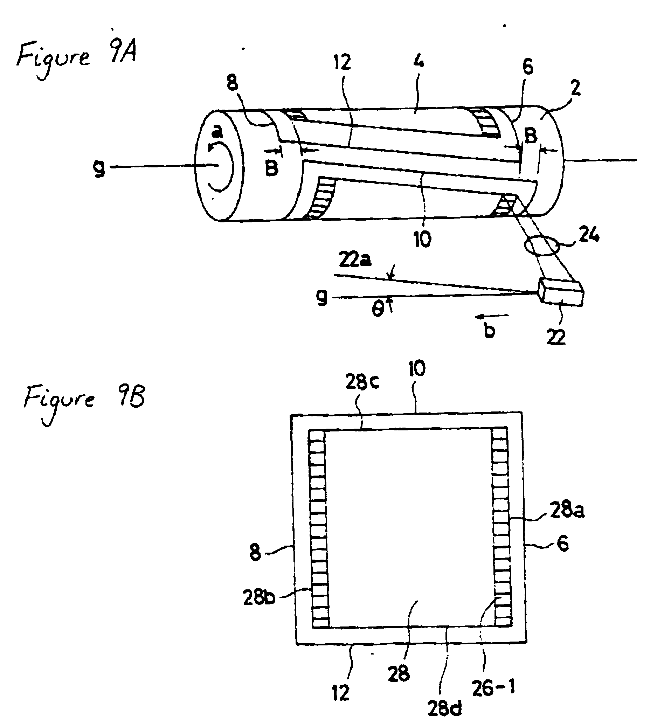

As mentioned above, in the prior art exposure apparatus, the light-transmitting elements of the array (22) are formed in a linear array that extends substantially parallel to the drum axis g. It will be apparent that if such an arrangement is used in accordance with the present invention, then each image strip (26-1, 26-2, 26-3, ...) will be formed on the plate (4) as a rhombus (see Figure 6). In other words, the leading and trailing edges of each strip (26) will be inclined to the leading and trailing edges (10,12) of the plate by angle $\theta$. Whilst for plates having the dimension of the order mentioned above, this distortion of each strip is not readily apparent to the eye the quality of the image can be improved further by tilting the light-transmitting array (22) by angle θ as shown in Figure 9a. According to this arrangement, each strip (26-1, 26-2, 26-3, ...) is formed as a rectangle without distortion.

In fact, it will be apparent from Figure 8 that where the array (22) is inclined by angle θ to the drum axis, the width B of each image strip also extends obliquely to the axis. The translational speed of the exposure bed (14) must thus be compensated accordingly. As will be seen from Figure 8, the separation in the axial direction of the start point of one image strip (26-2) from the start point of the preceding strip (26-1) is $B\cos θ$. Accordingly, the translational velocity of the optical bed (14) relative to the drum in the axial direction should be $U = B\cos θ/(0.6 - 5.4 \times 10^{-6})$ cm/second. However since the denominator here is very nearly equal 0.6, and as $\cos θ$ is very nearly 1.0, in fact a velocity of B divided by the time taken for complete revolution of the drum will suffice.

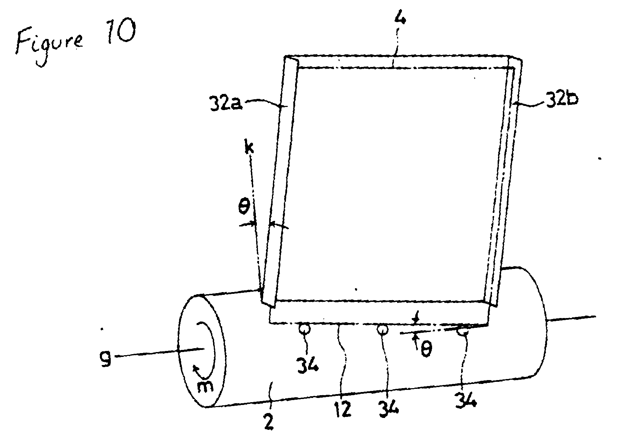

With reference to Figure 10, a pair of spaced, parallel guide rails (32a, 32b) are fixedly secured in juxtaposition with the rotary drum (2). The rails (32a, 32b) are designed to receive photo-sensitive printing plates (4) one at a time from a suitable plate feeding mechanism for supplying the plates onto the rotary drum (2). As will be seen from Figure 10, the rails are inclined with respect to the drum (2), such that each rail subtends an angle of θ to the normal k to the rotational axis g of the drum (2). The external surface of the drum (2) is provided with a plurality, in this case three of abutment members (34), which abutment members are arranged on a line that subtends an angle θ to the rotational axis g of the drum (2). A plate (4) that is delivered to the guide rails (32a, 32b) is fed onto the outer surface of the drum (2) until it abuts on the abutment members (34). Continued rotation of the drum causes the plate to be wound spirally on the drum (2) at the correct angle θ in accordance with the present invention.

Although in the embodiment illustrated in Figures 1 to 10 of the drawings, the printing plate (2) is carried on the external surface of the drum (2), the plate may, in alternative embodiments, be carried on an internal, substantially cylindrical surface of the drum. This is know in the art as an "inner face" type drum in which a lens means and a mirror are placed within the drum for reflecting the light beams from the exposure unit (22), so as to record the image on the plate within the drum. An inner face type exposure device provides a more compact apparatus as compared with the apparatus where the plate is carried exteriorly of the drum.

As an alternative to a laser light source which, as hereinbefore described, is split, modulated and transmitted through transmitting elements such as optical fibres, a plurality of light emitting diodes (LEDs) may be arranged in a linear row. Operation of each of the LEDs in such an array can be controlled by the computer C. As with the previously described multi-beam exposure unit, the discrete image element across the width of each image strip are formed simultaneously.

In yet another alternative embodiment of the present invention, a single beam exposure unit may be used which incorporates a vibration mirror that is fixed to the shaft of a vibration motor or galvanometer, and exposure of the plate may be performed by scanning the data within each strip by oscillation of the mirror within a micro-angle range. Another alternative embodiment uses a polariscope (known as an "acoustic optical polariscope") A polariscope is an exposure unit for diffracting an incident beam, freely changing the grid space with the use of a high frequency wave, so as to scan the beam within the width of each strip. A vibration mirror or polariscope can thus be used as the exposure unit (22) of the apparatus in accordance with the present invention. Further, alternative exposure units will be known to those skilled in the art.

## Claims

1. A method of exposing printing plates, particularly printing plates for use in newspaper printing, which plates are substantially rectangular, which method comprises winding a plate on a substantially cylindrical, rotary plate carrier drum; causing or allowing said drum to rotate such that the plate is moved progressively passed an exposing means for image-wise exposing the plate; causing or allowing relative translational movement of the exposing means and drum in a direction substantially parallel to the rotational axis of the drum; and intermittently actuating the exposing means; such that the image is formed on the plate in a plurality of contiguous, spiral strips, with one strip being formed in each full rotation of the drum; characterised by arranging said plate spirally on the drum relative to the rotational axis of the drum with a pitch substantially equal to the width of each image strip in the axial direction, and by advancing the actuation time of the exposing means relative to the angular velocity of the drum such that the strips form a rectangular image on the plate.

2. A method of exposing printing plates as claimed in claim 1, characterised in that the exposing means is arranged obliquely relative to the axis of the drum such that each image strip is rectangular.

3. A method as claimed in claim 1 or claim 2, characterised by moving the exposing means translationally relative to the drum.

4. A method as claimed in claim 1 or claim 2, characterised by moving the drum translationally relative to the exposing means.

5. Apparatus for exposing printing plates, particularly printing plates for use in newspaper printing, which apparatus comprises an exposing means 16,18,22,24; a substantially cylindrical, rotatory plate carrier drum 2 that is adapted to carry a substantially rectangular printing plate 4 thereon for progressive movement passed the exposing means for image-wise exposing the plate; moving means H for causing or allowing relative translational movement of the drum and exposing means in a direction substantially parallel to the rotational axis g of the drum; and actuating means C for intermittently actuating the exposing means such that an image is formed on the drum as a plurality of contiguous, spiral strips 26 with one strip being formed in each full rotation of the drum; characterised by plate positioning means 32a,32b,34 for arranging the plate spirally on the drum relative to the axis of the drum with a pitch substantially equal to the width of each image strip in the axial direction, and timing means A;E,F for advancing the timing of the actuation means relative to the angular velocity of the drum such that the image is formed rectangularly on the plate.

6. Apparatus for exposing printing plates as claimed in claim 5, characterised in that said drum 2 is adapted to carry the plate 4 exteriorly of the drum.

7. Apparatus for exposing printing plates as claimed in claim 5, characterised in that said drum 2 is adapted to carry the plate 4 interiorly of the drum, and the exposing means is disposed within the drum.

8. Apparatus for exposing printing plates as claimed in claim 5 or claim 6, characterised in that the exposing means is oriented obliquely relative to the axis of the drum such that each of the image strips 26 is formed rectangularly on the plate.

9. Apparatus for exposing printing plates as claimed in any of claims 5 to 8, characterised by detecting means for detecting the position of the drum, and in that said timing means is configured to control operation of the actuation means relative to the rotational position of the drum.

10. Apparatus for exposing printing plates as claimed in any of claims 5 to 8, characterised in that said timing means is configured to control the rotational speed of the drum relative to the frequency at which the exposing means is actuated.

11. Apparatus for exposing printing plates as claimed in claim 10, characterised in that said timing means comprises a crystal oscillator for controlling the rotational speed of the drum.

12. Apparatus for exposing printing plates as claimed in any of claims 5 to 11, characterised in that said positioning means comprises at least one guide rail 32a,32b, preferably two, which guide rail(s) is positioned juxtaposed the drum for feeding a plate to the drum, and is inclined with respect to the orthogonal to the axial direction.

13. Apparatus for exposing printing plates as claimed in any of claims 5 to 12, wherein said positioning means comprises abutment means 34 on the drum for aligning the plate.

14. Apparatus for exposing printing plates as claimed in any of claims 5 to 12, wherein said moving means is adapted for moving the exposing means translationally relative to the drum.

15. Apparatus for exposing printing plates as claimed in any of claims 5 to 12, wherein said moving means is adapted for moving the drum translationally relative to the exposing means.

16. Apparatus or method as claimed in any preceding claim, characterised in that said exposing means comprises a light source array which comprises a laser beam source or light-emitting diodes.

17. Apparatus or method as claimed in any preceding claim, characterised in that said exposing means comprises an oscillating mirror.

18. Apparatus or method as claimed in any preceding claim, characterised in that said exposing means comprises a polariscope.

Figure 1

EP 0 841 806 A2

Figure 2A

Figure 2B

Figure 3

Figure 4

Figure 5

Figure 6

Figure 7

Figure 8

Figure 9A

Figure 9B

Figure 10

Figure 77

Figure 12

$\theta = 0.17°$

$B = 3.6mm$

Figure 13